# EUROPÄISCHE PATENTSCHRIFT

(11) **EP 0 875 130 B1**
(45) Veröffentlichungstag und Bekanntmachung des Hinweises auf die Patenterteilung: **07.06.2006**
(21) Anmeldenummer: 97914080.3
(22) Anmeldetag: 20.01.1997
(51) Int. Cl.: H05K 9/00

(54) **ELEKTRISCH ABSCHIRMENDES GEHÄUSE**
ELECTRICALLY SCREENING HOUSING
BOITIER A EFFET DE BLINDAGE ELECTRIQUE

(30) Priorität: 19.01.1996 DE 19603161
(43) Veröffentlichungstag der Anmeldung: 04.11.1998
(73) Patentinhaber: Tiburtius, Bernd, 14532 Kleinmachnow (DE); Kahl, Helmut, 12307 Berlin (DE)
(72) Erfinder: Tiburtius, Bernd, 14532 Kleinmachnow (DE); Kahl, Helmut, 12307 Berlin (DE)
(74) Vertreter: Keussen, Christof
(86) Internationale Anmeldenummer: PCT/DE1997/000121
(87) Internationale Veröffentlichungsnummer: WO 1997/026782

(56) Entgegenhaltungen:
- EP-A- 0 629 114
- EP-A- 0 654 962
- EP-A- 0 676 340
- WO-A-91/01079
- DE-A- 3 812 943
- DE-A- 4 333 756

## Beschreibung

Die Erfindung betrifft ein elektrisch abschirmendes Gehäuse zur Aufnahme und elektromagnetischen Abschirmung von elektromagnetische Strahlung emittierenden oder gegenüber elektromagnetischer Strahlung empfindlichen Baugruppen gemäß dem Oberbegriff des Anspruchs 1.

Es ist bekannt, elektrisch abschirmende Gehäuse aus nicht elektrisch leitfähigem Material - insbesondere Kunststoff - zu fertigen, indem die vorgefertigten Gehäuseteile mit einem leitfähigen Material beschichtet werden, etwa durch Aufspritzen von Leitlack oder Bedampfen mit Aluminium (vgl. "Kunststoffgehäuse und EMV", elektronikindustrie 3 - 1992, S. 42). Solche Gehäuse wurden in der Regel mit vorgefertigten Dichtungen versehen, die aus leitfähigem Elastomer bestehen und bei der Montage eingelegt werden. DE 38 12 943 A1 zeigt ein innenbeschichtetes Abschirmgehäuse aus faserverstärktem Kunststoff mit einer solchen vorgefertigten, zwischen Nut und Feder eingelegten Dichtung.

Gehäuse der oben genannten Art - die mit der schnellen Verbreitung von Mobiltelefonen ganz besondere wirtschaftliche Bedeutung gewonnen haben - sind auch aus EP 0 629 114 B1 sowie aus EP 0 654 962 A1 bekannt.

Die dort beschriebenen Gehäuse sind aus zwei Teilen zusammengesetzt, die zur elektrischen Abschirmung des Gehäuseinnenraums (mindestens abschnittsweise) aus elektrisch leitfähigem Material bestehen oder aber mit solchem beschichtet sind und im zusammengesetzten Zustand einen Faradayschen Käfig bilden. Zur elektromagnetischen Abschirmung des Gehäuses im Fugenbereich zwischen den aneinanderstoßenden Gehäuseteilen ist weiterhin eine Abschirmdichtung vorgesehen, die aus einem elektrisch leitfähigen und zugleich elastischen Material besteht und sich an Oberflächentoleranzen und -unebenheiten anpaßt, so daß auch bei Großserienfertigung eine sehr hohe Qualtität der Abschirmung des Gehäuseinneren gewährleistet werden kann. Gemäß den obigen Druckschriften ist diese Abschirmdichtung direkt auf mindestens einem der Gehäuseteile gefertigt, wobei noch ein zusätzlicher Träger in den Aufbau einbezogen sein kann.

Durch diesen Aufbau läßt sich das Gehäuse in einfacher Weise beispielsweise zu Wartungszwecken oder zur Erneuerung einer in dem Gehäuse befindlichen Batterie öffnen und anschließend unter Erhaltung des Abschirmeffektes wieder verschließen.

Bei der Herstellung eines Materials für die Abschirmdichtung ist es jedoch für bestimmte Anwendungen schwierig, einen optimalen Kompromiß zwischen hoher Elastizität, hoher Leitfähigkeit und möglichst niedrigen Materialkosten zu finden. Ein aus physikalischer Sicht vorteilhaftes Material ist eine mit einem hohen Anteil von Silberpulver gefüllte Kunststoffmasse, diese ist aber relativ teuer.

Der Erfindung liegt somit die Aufgabe zugrunde, ein elektrisch abschirmendes Gehäuse der eingangs genannten Art zu schaffen, das sich kostengünstig herstellen läßt.

Die Aufgabe wird, ausgehend von einem Gehäuse gemäß dem Oberbegriff des Anspruchs 1, durch die kennzeichnenden Merkmale des Anspruchs 1 bzw. - hinsichtlich des Herstellungsverfahrens - durch die Merkmale des Anspruchs 8 gelöst.

Die Erfindung schließt die technische Lehre ein, die Abschirmdichtung zur Kostenersparnis nicht vollständig aus einem elektrisch leitfähigen und gleichzeitig flexiblen Material zu fertigen, sondern zur Ausfüllung der Fuge ein an Ort und Stelle gebildetes Element aus elektrisch im wesentlichen nicht-leitfähigem, aber nachgiebigem (elastischem) Material einzusetzen und die elektrische Abschirmung im Fugenbereich durch eine an diesem Element anhaftende und nahtlos in die Abschirmung der im wesentlichen starren Gehäusewandungen übergehende Schicht aus elektrisch leitfähigem Material zu realisieren.

Das Dichtelement hat hierbei primär die Funktion, den Fugenzwischenraum auszufüllen, um beispielsweise bei einem durch fertigungsbedingte Paßfehler oder Oberflächenunebenheiten verursachten mechanischen Spiel der Gehäuseteile das Gehäuseinnere zuverlässig gegen Feuchtigkeit und Staub zu schützen und Relativbewegungen zwischen den Gehäuseteilen zu verhindern. Aufgrund der verbesserten mechanischen Eigenschaften der Dichtmasse ist es auf diese Weise möglich, den Gehäuseinnenraum dauerhaft hermetisch abzudichten. Zugleich ist das Dichtelement natürlich Träger eines Abschnitts der elektromagnetischen Abschirmung und sichert deren Geschlossenheit. Besonders vorteilhaft ist es im Hinblick hierauf, ein hochgradig elastisches Material und/oder eine formelastische Gestalt der Dichtung zu wählen, aufgrund derer bei der Montage der Gehäuseteile durch die Kompression und/oder eine Flexion des Dichtelements eine Vorspannung zwischen den Gehäuseteilen aufgebaut wird, die beispielsweise die Lösung einer Schraub- oder Klemmverbindung verhindern kann. Die Erfindung ist jedoch nicht auf die Verwendung material- und/oder formelastischer Trägerelemente beschränkt, sondern läßt sich grundsätzlich auch mit einem plastisch verformbaren Dichtelement realisieren.

In der bevorzugten Ausführung der Erfindung ist die aus elektrisch leitfähigem Material bestehende Beschichtung zusammenhängend (insbesondere in einem einzigen Arbeitsgang) auf die Oberfläche des Dichtelements und der starren Gehäusewandung aufgebracht.

In einer weiteren Variante der Erfindung ist die Abschirmung in Sandwich-Bauweise aufgebaut, wobei das Trägerelement aus mindestens zwei Schichten aus elektrisch nicht-leitfähigem, aber nachgiebigem Material besteht, zwischen denen die Schicht aus elektrisch leitfähigem Material angeordnet ist, welche die elektromagnetische Abschirmung bewirkt. Durch die Anordnung der aus elektrisch leitfähigem Material bestehenden Schicht in einem im wesentlichen deformationsfreien Bereich zwischen zwei deformierbaren Schichten bzw. Strängen des elastischen Elements wird vorteilhaft einer Rißbildung in dem elektrisch leitfähigen Material entgegengewirkt, was speziell für Konstruktionen von Bedeutung ist, bei denen eine starke Deformation des Abschirmelements beim Zusammensetzen der Gehäuseteile auftreten soll oder kann.

In einer weiteren vorteilhaften Ausführung ist zur Verhinderung einer Rißbildung vorgesehen, die aus elektrisch leitfähigem Material bestehende Schicht sehr dünn auszuführen, da die Biegespannungen und damit die Rißneigung bei vorgegebener Biegung mit der Schichtdicke zunehmen. Die Dicke der aus elektrisch leitfähigem Material bestehenden Schicht ist deshalb wesentlich (vorzugsweise um eine bis drei Größenordnung/en) geringer als die Fugenbreite.

Die Aufbringung der Abschirmungsschicht auf das Dichtelement bzw. - im Falle einer Sandwich-Bauweise - auf eine Schicht oder einen Strang desselben kann auf verschiedene Arten erfolgen. Zur Erreichung gleichmäßiger Schichtdicken eignen sich die als solche bekannten Verfahren des Besprühens mit Leitlack oder Bedampfens mit einem reinen Metall, insbesondere aber auch eine galvanische Metallisierung und die - besonders aus der Herstellung elektronischer Bauelemente bekannten - Verfahren der Gasphasenabscheidung, wie Sputtern und CVD (chemische Gasphasenabscheidung).

In einer vorteilhaften Ausführung wird im Rahmen der letztgenannten Verfahren die Beschichtung durch gezieltes Aufwachsen von Kristalliten in Abstimmung auf die konstruktiv vorgegebenen Richtungen der mechanischen Beanspruchung der Unterlage (speziell des Dichtelementes) erzeugt. Hierbei können - insbesondere in mehrschichtigem Aufbau - kleine plattenförmige Flächenelemente auf der Oberfläche ausgebildet werden, die innerhalb der Schicht nur lose zusammenhängen und somit bei einer Biegung des Trägerelements in gewissem Grade gegeneinander verschieblich sind, was ebenfalls einer etwaigen Rißbildung in der Abschirmungsschicht entgegenwirkt. Besonders günstig ist hierfür eine schuppen- oder dachziegelartige Anordnung der besagten Kristallite, die etwa durch Schrägbedampfen oder Besputtern eines geneigten Substrats bei geeigneter Einstellung der Beschichtungsparameter, neben der Substratorientierung etwa der Substrattemperatur, der Materialgasflußrate etc., erzeugt werden kann.

In einer weiteren Variante der Erfindung erfolgt die Aufbringung der elektrisch leitfähigen Schicht auf das Trägerelement nicht im mechanisch entspannten Zustand, sondern in einem Zustand vorbestimmter Kompression und/oder Flexion des Dichtelements. Hierdurch wird verhindert, daß eine Rißbildung in der elektrisch leitfähigen Schicht zu einer Herabsetzung der elektromagnetischen Abschirmwirkung des Abschirmelements führt. Die Erfindung geht in dieser Variante von dem Gedanken aus, daß sich eine Rißbildung in der elektrisch leitfähigen Schicht wegen der beim Zusammenbau des Gehäuses erfolgenden Deformation des Abschirmelements nur schwer unter allen Umständen verhindern läßt, so daß es wichtig ist, die negativen Folgen einer derartigen Rißbildung auf das elektromagnetische Abschirmverhalten zu verringern. Durch die Aufbringung der elektrisch leitfähigen Schicht im deformierten Zustand des Dichtelements entstehen Risse ggfs. anschließend bei dessen Entspannung, und diese werden bei der späteren montagebedingten Deformation des Dichtelements beim Zusammenbau des Gehäuses wieder weitgehend geschlossen, da das Dichtelement dann im wesentlichen dieselbe Form wie bei der Aufbringung der leitfähigen Schicht annimmt.

Weitere vorteilhafte Weiterbildungen sind in den Unteransprüchen gekennzeichnet bzw. werden nachstehend zusammen mit der Beschreibung der bevorzugten Ausführung der Erfindung anhand der Figuren näher dargestellt. Es zeigen:
- Figur 1: als bevorzugtes Ausführungsbeispiel der Erfindung ein aus zwei Gehäuseteilen zusammengesetztes Gehäuse zur elektromagnetischen Abschirmung einer elektronischen Schaltung in perspektivischer Explosionsdarstellung,
- Figuren 2a und 2b: Querschnitte durch einen Abschnitt der Wandung des Gehäuses aus Figur 1 im Bereich der Fuge zwischen den Gehäuseteilen gemäß zwei unterschiedlichen Ausbildungen,
- Figur 3: eine weitere Ausführungsform des in Figur 1 gezeigten Gehäuses, ebenfalls in Querschnittsdarstellung, und
- Figuren 4a und 4b: eine Querschnittsdarstellung eines Gehäuseabschnitts bei einer weiteren Ausführungsform (a) mit entspanntem Dichtelement und (b) im montierten Zustand des Gehäuses.

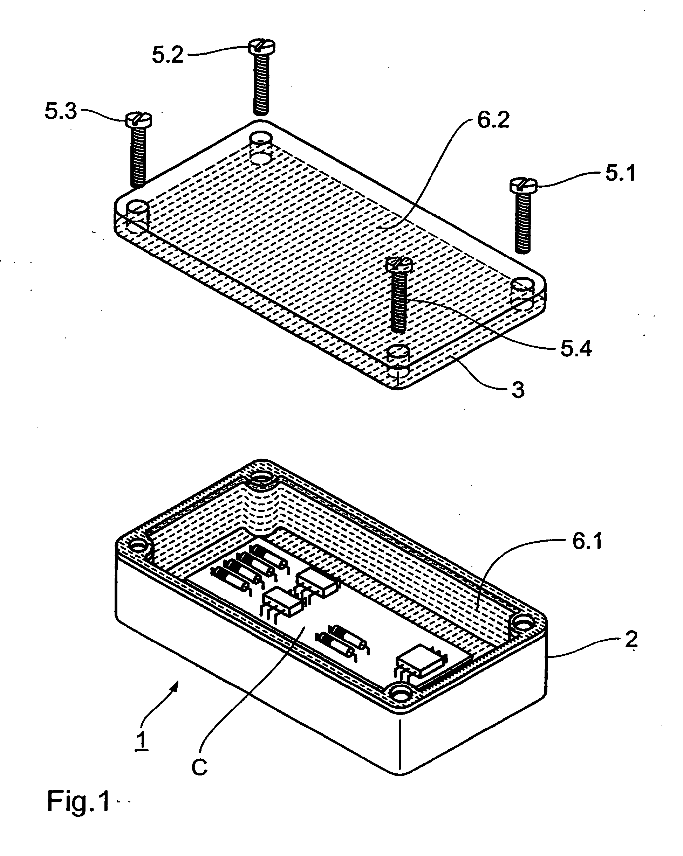

In Figur 1 ist ein Gehäuse 1 für eine elektronische Schaltung C dargestellt, das diese elektromagnetisch abschirmt. Zum einen wird hierdurch verhindert, daß die Schaltung C durch von außen eintretende elektromagnetische Strahlung gestört wird, so daß der Betrieb der Schaltung 1 auch in elektromagnetisch stark gestörten Umgebungen möglich ist. Zum anderen kann die Abschirmung verhindern, daß die beim Betrieb entstehende elektromagnetische Strahlung aus dem Gehäuse austritt, was zu Störungen in der Umgebung führen oder Möglichkeiten einer unbefugten Kenntnisnahme von Funktionsabläufen in der Schaltung bieten könnte.

Das Gehäuse besteht aus einem wannenartigen Unterteil 2 mit rechteckigem Öffnungsquerschnitt und einem plattenförmigem Deckel 3 zum Verschließen des Unterteils 2 und umfaßt eine direkt auf dem Unterteil 2 gebildeten ("aufdispensierten") Dichtung 4 zur Abdichtung der Fuge zwischen dem Unterteil 2 und dem Deckel 3. Die Verbindung des Deckels 3 mit dem Unterteil 2 erfolgt über eine Schraubverbindung, indem vier Schrauben 5.1 bis 5.4 durch entsprechende Bohrungen in den Ecken des Deckels 3 durchgeführt und in Schraubgewinde in dem Unterteil 2 eingedreht werden.

Sowohl das Unterteil 2 als auch der Deckel 3 sind aus Kunststoff spritzgegossen, und sämtliche Innenflächen - unter Einschluß der Oberfläche der aufdispensierten Dichtung 4 - sind mit einer (bei jedem Gehäuseteil in sich zusammenhängenden) leitfähigen Beschichtung 6.1 bzw. 6.2 versehen. Die Beschichtungen 6.1 und 6.2 stehen im verschraubten Zustand des Gehäuses 1 in elektrischem Kontakt miteinander und bilden einen elektromagnetisch abschirmenden Faradayschen Käfig.

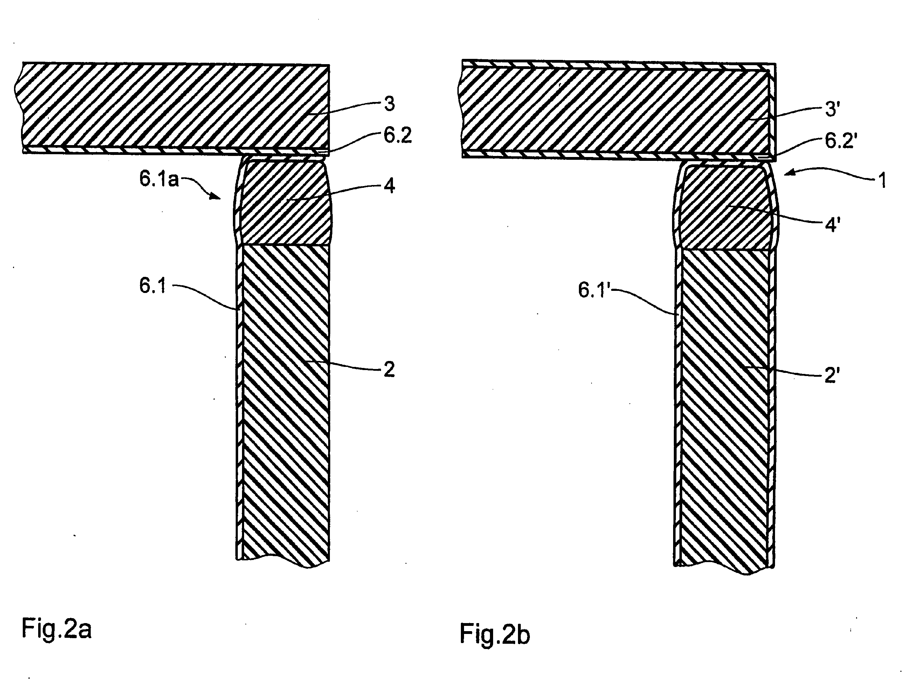

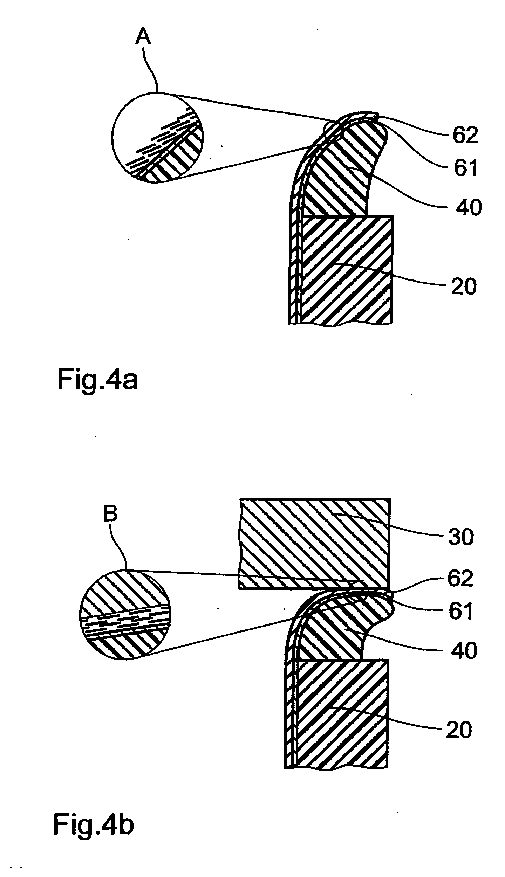

Die Abschirmdichtung besteht demnach - wie aus der in Figur 2a gezeigten Querschnittsdarstellung ersichtlich - aus einem mit dem Unterteil 2 festhaftend verbundenen elastischen Dichtelement 4 aus einem üblichen elastischen Kunststoff (beispielsweise ungefülltem Silikon oder Neopren) und dem zugehörigen Abschnitt 6.1a der leitfähigen Beschichtung 6.1 (etwa aus aufgedampftem Aluminium, Kupfer oder Cr-Ni oder einer ein- oder mehrkomponentigen galvanischen Beschichtung). Es kann auch - wie in Fig. 4a und 4b gezeigt - eine als solche bekannte, aber hier in den physikalischen Eigenschaften auf das nachgiebige Dichtungsmaterial abzustimmende Haftvermittlerschicht vorgesehen sein.

Fig. 2b zeigt als Gehäuse 1' eine Abwandlung dieses Gehäuses, bei der beide Gehäuseteile 2', 3' eine allseitige galvanische Beschichtung 6.1' bzw. 6.2' unter Einschluß der vorab auf das Unterteil 2' aufgedrückten und unter Luftzutritt oder durch Heißvulkanisieren auf dieser festhaftend ausgehärteten Dichtung 4' aufweisen.

In einer weiteren (nicht dargestellten) Modifikation ist die Dichtung gemeinsam mit einem der Gehäuseteile aus zwei unterschiedlichen Polymeren formgespritzt, wobei eine Abstimmung der eingesetzten Monomere insbesondere im Hinblick auf die Extrusionsparameter und ihre Thixotropie sowie Vernetzungstemparatur und -geschwindigkeit vorgenommen ist.

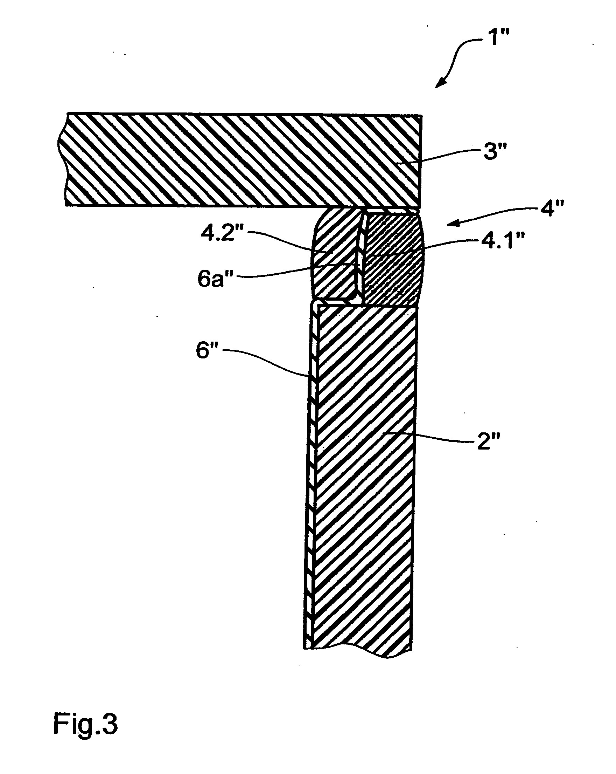

Fig. 3 zeigt als weitere Ausführungsform ein dem Gehäuse 1 aus Fig. 1 äußerlich gleichendes Gehäuse 1", dessen Unterteil 2" wieder aus einem Spritzguß-Kunststoffmaterial besteht, dessen Deckel 3" aber aus massivem Aluminiumblech gefertigt ist. Hier ist daher nur am Unterteil eine Metallbeschichtung 6" vorgesehen. Diese bedeckt auch einen im Bereich der Außenfläche des Unterteils aufgebrachten Dichtungsstrang 4.1". Ein nach dem Auftrag der Metallschicht in einem separaten Auftragsschritt nahe der Innenkante des Unterteils aufdispensierter zweiter Dichtungsstrang 4.2" komplettiert die Dichtung 4". Diese hat hier also einen Sandwich-Aufbau, bei dem die leitfähige Beschichtung weitgehend von aus der Verformung der Dichtung beim Schließen des Gehäuses resultierenden Zugkräften entlastet und daher die Gefahr einer Bildung von Rissen in der Abschirmschicht weitgehend gebannt ist. Die Anordnung des leitfähigen Schichtabschnitts 6a" in der Mitte zwischen den beiden Strängen 4.1", 4.2" des Dichtelements ist insofern vorteilhaft, als die mechanische Biegebeanspruchung der Beschichtung in diesem Fall bei der beim Zusammenschrauben des Gehäuses auftretenden einachsigen Druckbeanspruchung des Dichtelementes 4" minimal ist, wodurch die Gefahr einer Rißbildung verringert wird. Der Rißbildung wird zusätzlich durch die mechanische Fixierung der elektrisch leitfähigen Schicht zwischen den beiden Schichten des Dichtelements entgegengewirkt.

Dieses Ziel kann - zumindest bis zu einem gewissen Grade - auch bei den einfacheren Aufbauten der Fig. 2a und 2b erreicht werden, indem die Dicke der metallischen Beschichtung im Vergleich zu den Abmessungen der Dichtung gering gehalten wird. Je nach Größe des Gehäuses, zu berücksichtigenden Fertigungstoleranzen und erforderlicher Abschirmwirkung kann sie in vorteilhafter Weise bis hinab zu einigen zehn oder auch nur einigen Mikrometern festgelegt werden. Dies verkürzt - speziell bei Erzeugung einer sehr reinen und in vorteilhafter Weise hoch leitfähigen Schicht durch ein Gasphasen- bzw. Vakuumverfahren - auch die Prozeßdauer und verringert die Kosten.

Eine spezielle Schichtstruktur mit verringerter Rißbildungsneigung ist in Fig. 4a und 4b (im entspanntem bzw. montierten und dadurch verformten Zustand) gezeigt.

Hier weist ein unteres Gehäuseteil 20 ebenso wie ein lippenförmiges elastisches Dichtelement 40 eine Haftvermittlerschicht 61 und eine metallische Beschichtung 62 auf, wobei letztere beispielsweise durch orientiertes Aufwachsen von Kristalliten auf die Oberfläche in einem Vakuumprozeß erzeugt ist. Das Kristallwachstum wird hierbei so gesteuert, daß auf der Oberfläche mindestens des Dichtelementes 40 kleine, schuppenartige Flächenelemente entstehen, die die Oberfläche praktisch vollständig in mehrfacher Überlappung bedecken und gegeneinander in gewissem Maße verschiebbar sind (vgl. den skizzenartig vergrößerten Ausschnitt "A" in Fig. 4a). Hierdurch wird verhindert, daß die elektrisch leitfähige Beschichtung 62 beim Zusammenbau des Gehäuses aufgrund der montagebedingten Deformation der Dichtung 40 aufreißt, was zu einer Beeinträchtigung der elektromagnetischen Abschirmwirkung führen würde. Vielmehr werden beim Schließen des metallischen Deckels 30 die Schichtelemente unter dem Druck des Deckels und der Wirkung der aus der Verbiegung des Profilquerschnitts resultierenden Zugkraft überlappend einachsig orientiert und bilden eine kontinuierliche Schicht (vgl Ausschnitt "B" in Fig. 4b).

Die lippenförmige und - wie Fig. 4b zeigt - bei der Montage primär auf Biegung beanspruchte - Gestalt des Dichtelementes 40 ist speziell im Hinblick auf die erwähnte Struktur der Schicht 62 gewählt. Diese Schichtstruktur entfaltet aber ähnlich vorteilhafte Wirkung an einem annähernd kreis- oder halbkreisförmigen und primär einer Kompression unter-worfenen Dichtprofil, denn auch bei einem solchen wird infolge der Deformation der Umfang vergrößert, und die hierdurch gedehnte schuppenartige Struktur gewährleistet dann die Geschlossenheit der Beschichtung auch im montierten Zustand des Gehäuses.

Die Erfindung beschränkt sich in ihrer Ausführung nicht auf die vorstehend angegebenen bevorzugten Ausführungsbeispiele. Vielmehr ist eine Anzahl von Varianten denkbar, welche von der dargestellten Lösung auch bei grundsätzlich anders gearteten Ausführungen Gebrauch machen.

So kann in technologisch einfacher Weise eine typischerweise beim Spritzgießen eines Kunststoff-Gehäuseteils gebildete dünne, im Querschnitt (ähnlich Fig. 4a) annähernd C-förmig auf dem Gehäuseteil aufstehende Lippe vermittels ihrer Formelastizität zugleich als Dichtelement und Spaltabschirmung dienen, wenn sie am Gehäuseteil belassen und gemäß obigem zusammen mit diesem metallisch beschichtet wird. Die Dichtlippe muß nicht notwenig lückenlos längs der Gehäuseteilkante ausgebildet sein.

## Patentansprüche

1. Elektrisch abschirmendes Gehäuse (1) zur Aufnahme und elektromagnetischen Abschirmung von elektromagnetische Strahlung emittierenden oder gegenüber elektromagnetischer Strahlung empfindlichen Bauelementen bzw. Baugruppen (C), wobei das Gehäuse wenigstens zwei Gehäuseteile (2, 3) mit elektrisch abschirmenden Wandungen aufweist, wobei an mindestens einem Gehäuseteil (2) im Bereich einer Fuge zu einem anderen Gehäuseteil (3) ein auf einem Gehäuseteil (2) gebildetes Dichtelement (4) festhaftend vorgesehen ist,
**dadurch gekennzeichnet, daß** das Dichtelement (4) aus elektrisch nichtleitendem Material besteht und mindestens ein Abschnitt des dieses Dichtelement tragenden Gehäuseteils (2) aus im wesentlichen nichtleitendem Material, nämlich Kunststoffmaterial, besteht und das Dichtelement und das Gehäuseteil zur elektromagnetischen Abschirmung mit einer zusammenhängenden, sich mindestens über die Fuge erstreckenden und an dem Dichtelement (4) und dem Gehäuseteil (2) anhaftenden, die Abschirmung des Gehäuseteils realisierenden, elektrisch leitfähigen Schicht 6.1 bedeckt sind.

2. Gehäuse nach Anspruch 1,
**dadurch gekennzeichnet, daß** die elektrisch leitfähige Schicht (6) eine gegenüber den Abmessungen des Dichtelementes (4) dünne Metallschicht oder metallgefüllte Schicht ist.

3. Gehäuse nach Anspruch 1 oder 2,
**dadurch gekennzeichnet, daß** die elektrisch leitfähige Schicht (6) die Oberfläche des das Dichtelement tragende Gehäuseteils (2) bedeckt.

4. Gehäuse nach einem der vorhergehenden Ansprüche,
**dadurch gekennzeichnet, daß**die elektrisch leitfähige Schicht durch Sprühbeschichtung, Galvanisieren oder in einem Vakuum- bzw. Gasphasenprozeß aufgebracht ist.

5. Gehäuse nach einem der vorhergehenden Ansprüche,
**dadurch gekennzeichnet, daß** die elektrisch leitfähige Schicht (6) einen Verbund aus einer Vielzahl von mindestens die gehäuseinnen- oder -außenseitige Oberfläche des Dichtelements (4) im wesentlichen vollständig bedeckenden, sich vorzugsweise überlappenden, plattenförmigen Schichtelementen aufweist, die zur Verhinderung eines Abplatzens der Beschichtung (6) bei einer montagebedingten Deformation des Abschirmelements (4) relativ zueinander längs der Oberfläche verschieblich sind.

6. Gehäuse nach einem der vorhergenden Ansprüche,
**dadurch gekennzeichnet, daß** das Dichtelement (4") in Sandwich-Bauweise aufgebaut ist derart, daß mindestens zwei Schichten bzw. Stränge (4.1 ", 4.2") aus Dichtmaterial vorgesehen sind, zwischen denen die Schicht (6a") aus elektrisch leitfähigem Material angeordnet ist.

7. Gehäuse nach einem der vorhergehenden Ansprüche,
**dadurch gekennzeichnet, daß** sämtliche Gehäuseteile (2, 3) aus, insbesondere spritzgeformtem, Kunststoff bestehen und zur elektromagnetischen Abschirmung des Gehäuseinnenraums an ihrer Innenseite und/oder Außenseite eine elektrisch leitfähige Beschichtung aufweisen.

8. Gehäuse nach einem der Ansprüche 1 bis 6,
**dadurch gekennzeichnet, daß** wenigstens ein Gehäuseteil (3) aus einem elektrisch leitfähigem Material besteht.

9. Verfahren zur Herstellung eines Gehäuses nach einem der vorhergehenden Ansprüche mit den Schritten
- Formen mindestens zweier Gehäuseteile, wobei mindestens eines zumindest abschnittsweise aus nichtleitendem Material gebildet wird oder mindestens ein Gehäuseteil elektrisch leitfähiges Material aufweist;
- Bilden eines strangförmigen Dichtelements mit vorbestimmtem Querschnitt und vorbestimmter Gestalt auf einem Kantenbereich mindestens eines Gehäuseabschnitts;
- Aufbringen einer zusammenhängenden leitfähigen Beschichtung auf den, insbesondere nichtleitenden, Gehäuseabschnitt und das dort gebildete Dichtelement und
- Montieren der Gehäuseteile mit dem Dichtelement und der leitfähigen Beschichtung dazwischen.

10. Verfahren nach Anspruch 8,
**dadurch gekennzeichnet, daß** das strangförmige Dichtelement durch Aufspritzen einer pastösen Masse und anschließendes Aushärten derselben an Ort und Stelle auf dem Gehäuseabschnitt gebildet wird.

11. Verfahren nach Anspruch 8,
**dadurch gekennzeichnet, daß** das Dichtelement zusammen mit dem tragenden Gehäuseteil, insbesondere materialeinheitlich oder durch einstufiges Spritzformen verschiedener Materialien, gebildet wird.

12. Verfahren nach einem der Ansprüche 8 bis 10,
**dadurch gekennzeichnet, daß** die leitfähige Beschichtung durch Sprühbeschichtung, Galvanisieren, Bedampfen oder Besputtern aufgebracht wird.

13. Verfahren nach Anspruch 11,
**dadurch gekennzeichnet, daß**das Bedampfen oder Besputtern unter Schrägstellung der Dichtelementoberfläche zur Materialquelle ausgeführt wird derart, daß sich eine schuppenartige Struktur der leitfähigen Schicht ausbildet.

14. Verfahren nach einem der Ansprüche 8 bis 12,
**dadurch gekennzeichnet, daß** das Dichtelement (4) vor dem Aufbringen der leitfähigen Schicht in eine vorbestimmte Gestalt verformt wird, insbesondere derart, daß die Form des Dichtelements (4) im verformten Zustand im wesentlichen gleich der Form ist, die es im zusammengesetzten Zustand des Gehäuses annimmt.

## Claims

1. Electrically shielding housing (1) for holding and electromagnetically shielding components or subassemblies (C) which emit or are sensitive to electromagnetic radiation, wherein the housing comprises at least two housing parts (2, 3) with electrically shielding walls, wherein, at least at one housing part (2), a sealing element (4), which is formed on one housing part (2), is provided in a firmly adhering manner in the region of a joint with another housing part (3),
**characterised in that** the sealing element (4) consists of electrically non-conductive material, and at least one portion of the housing part (2) bearing this sealing element consists of substantially non-conductive material, namely plastics material, and, for the purpose of electromagnetic shielding, the sealing element and the housing part are covered with a continuous electrically conductive layer (6.1) which extends at least over the joint, adheres to the sealing element (4) and the housing part (2) and shields the housing part.

2. Housing according to Claim 1,
**characterised in that** the electrically conductive layer (6) is a metal layer or metal-filled layer which is thin in comparison with the dimensions of the sealing element (4).

3. Housing according to Claim 1 or 2,
**characterised in that** the electrically conductive layer (6) covers the surface of the housing part (2) bearing the sealing element.

4. Housing according to any one of the preceding Claims,
**characterised in that** the electrically conductive layer is applied by spray coating, electrodeposition or in a vacuum or vapour-phase process.

5. Housing according to any one of the preceding Claims,
**characterised in that** the electrically conductive layer (6) comprises a composite structure of a plurality of plate-shaped layer elements which cover at least the surface of the sealing element (4) which is on the inside or the outside of the housing, which preferably overlap and which can be displaced relative to one another along the surface in order to prevent the coating (6) from chipping off should the shielding element (4) undergo deformation due to assembly.

6. Housing according to any one of the preceding Claims,
**characterised in that** the sealing element (4") is of sandwich construction such that at least two layers or strands (4.1", 4.2") of sealing material are provided, between which layers or strands the layer (6a") of electrically conductive material is disposed.

7. Housing according to any one of the preceding Claims,
**characterised in that** all the housing parts (2, 3) consist of, in particular injection-moulded, plastics material and, for the purpose of electromagnetic shielding of the housing interior, comprise an electrically conductive coating at their inside and/or outside.

8. Housing according to any one of Claims 1 to 6,
**characterised in that** at least one housing part (3) consists of an electrically conductive material.

9. Method for producing a housing according to any one of the preceding Claims, comprising the steps
- moulding at least two housing parts, wherein at least one is formed at least in portions from non-conductive material or at least one housing part comprises electrically conductive material;
- forming a strand-shaped sealing element of a predetermined cross section and a predetermined shape on an edge region of at least one housing portion;
- applying a continuous conductive coating to the, in particular non-conductive, housing part and the sealing element formed here and
- assembling the housing parts with the sealing element and the conductive coating in between.

10. Method according to Claim 8,
**characterised in that** the strand-shaped sealing element is formed by spraying on a paste-like material and subsequently hardening the latter in situ on the housing portion.

11. Method according to Claim 8,
**characterised in that** the sealing element, together with the bearing housing part, is formed in particular integrally or through single-stage injection moulding of different materials.

12. Method according to any one of Claims 8 to 10,
**characterised in that** the conductive coating is applied by spray coating, electrodeposition, vapour deposition or sputtering.

13. Method according to Claim 11,
**characterised in that** the vapour deposition or sputtering is carried out with the sealing element surface inclined relative to the material source such that a scale-like structure of the conductive layer forms.

14. Method according to any one of Claims 8 to 12,
**characterised in that**, before applying the conductive layer, the sealing element (4) is shaped into a predetermined shape, in particular such that the form of the sealing element (4) in the shaped state is substantially identical to the form which it takes on when the housing is in the assembled state.

## Revendications

1. Boîtier de protection électrique (1) pour le logement et la protection électromagnétique de composants ou de modules (C) émettant un rayonnement électromagnétique ou sensibles au rayonnement électromagnétique, le boîtier comportant au moins deux parties (2, 3) avec des parois de protection électrique, un élément d'étanchéité (4) adhérent formé sur une partie de boîtier (2) étant prévu dans au moins une partie de boîtier (2) dans la zone d'un joint avec une autre partie de boîtier (3),
**caractérisé en ce que** l'élément d'étanchéité (4) est constitué d'une matière non électro-conductrice et au moins une section de la partie de boîtier (2) portant cet élément d'étanchéité est constituée d'une matière sensiblement non électro-conductrice, c'est-à-dire une matière plastique et, pour la protection électromagnétique, l'élément d'étanchéité et la partie de boîtier sont recouverts d'une couche 6.1 électro-conductrice continue s'étendant au moins sur le joint et adhérant à l'élément d'étanchéité (4) et à la partie de boîtier (2), constituant la protection de la partie de boîtier.

2. Boîtier selon la revendication 1,
**caractérisé en ce que** la couche électro-conductrice (6) est une couche métallique ou une couche remplie de métal mince par rapport aux dimensions de l'élément d'étanchéité (4).

3. Boîtier selon la revendication 1 ou 2,
**caractérisé en ce que** la couche électro-conductrice (6) recouvre la surface de la partie de boîtier (2) portant l'élément d'étanchéité.

4. Boîtier selon l'une quelconque des revendications précédentes,
**caractérisé en ce que** la couche électro-conductrice est appliquée par enduction par pulvérisation, par galvanisation ou à l'aide d'un procédé sous vide ou en phase gazeuse.

5. Boîtier selon l'une quelconque des revendications précédentes,
**caractérisé en ce que** la couche électro-conductrice (6) comprend une stratification constituée d'une pluralité d'éléments de stratification en forme de plaque, de préférence se chevauchant, recouvrant sensiblement complètement au moins la surface du côté intérieur ou extérieur du boîtier de l'élément d'étanchéité (4) qui sont déplaçables les uns par rapport aux autres le long de la surface pour empêcher un écaillage du revêtement (6) dans le cas d'une déformation de l'élément de protection (4) due au montage.

6. Boîtier selon l'une quelconque des revendications précédentes,
**caractérisé en ce que** l'élément d'étanchéité (4") est construit à la manière d'un sandwich de manière à prévoir au moins deux couches ou cordons (4.1", 4.2") de matière d'étanchéité entre lesquelles est placée la couche constituée d'une matière électro-conductrice.

7. Boîtier selon l'une quelconque des revendications précédentes,
**caractérisé en ce que** toutes les parties de boîtier (2, 3) sont constituées de matière plastique, en particulier moulée par injection, et comportent un revêtement électro-conducteur sur leur face intérieure et/ou sur leur face extérieure pour la protection électromagnétique de l'intérieur du boîtier.

8. Boîtier selon l'une quelconque des revendications 1 à 6,
**caractérisé en ce qu'**au moins une partie de boîtier (3) est constituée d'une matière électro-conductrice.

9. Procédé pour la fabrication d'un boîtier selon l'une quelconque des revendications précédentes, avec les étapes de
- formation d'au moins deux parties de boîtier, l'une au moins étant constituée, au moins par sections, d'une matière non électro-conductrice ou au moins une partie de boîtier comportant une matière électro-conductrice ;
- formation d'un élément d'étanchéité en forme de cordon avec une section transversale prédéterminée et une configuration prédéterminée sur une zone de bord d'au moins un tronçon de boîtier ;
- application d'un revêtement conducteur continu sur le tronçon de boîtier, en particulier non conducteur, et l'élément d'étanchéité formé là et
- montage des parties de boîtier avec l'élément d'étanchéité et le revêtement conducteur entre elles.

10. Procédé selon la revendication 8,
**caractérisé en ce que** l'élément d'étanchéité en forme de cordon est formée par pulvérisation d'une masse pâteuse et par durcissement consécutif de celle-ci sur place sur le tronçon de boîtier.

11. Procédé selon la revendication 8,
**caractérisé en ce que** l'élément d'étanchéité est formé conjointement avec la partie de boîtier le portant, en particulier par une matière homogène ou par moulage par injection à une étape de différentes matières.

12. Procédé selon l'une quelconque des revendications 8 à 10,
**caractérisé en ce que** le revêtement électro-conducteur est appliqué par enduction par pulvérisation, par galvanisation, par vaporisation ou par pulvérisation cathodique.

13. Procédé selon la revendication 11,
**caractérisé en ce que** la vaporisation ou la pulvérisation cathodique est réalisée en plaçant la surface de l'élément d'étanchéité en position inclinée par rapport à la source de matière de telle sorte qu'il se forme une structure en flocons de la couche électro-conductrice.

14. Procédé selon l'une quelconque des revendications 8 à 12,
**caractérisé en ce que** l'élément d'étanchéité (4) est façonné avant l'application de la couche électro-conductrice pour prendre une forme prédéterminée, en particulier de manière à ce que la forme de l'élément d'étanchéité (4) à l'état façonné soit sensiblement identique à la forme qu'il prend à l'état assemblé du boîtier.
